# EUROPEAN PATENT APPLICATION

(11) **EP 1 632 586 A2**
(43) Date of publication of application: **08.03.2006**
(21) Application number: 05017228.7
(22) Date of filing: 08.08.2005
(51) Int. Cl.: C23C 14/24

(54) **Film formation source, vacuum film formation apparatus, and method of manufacturing organic EL panel**

(30) Priority: 24.08.2004 JP 2004243298
(71) Applicant: Tohoku Pioneer Corporation, Tendo-shi, Yamagata-ken (JP)
(72) Inventor: Abiko, Hirosi, Yonezawa-shi Yamagata-ken 992-1128 (JP); Masuda, Daisuke, Yonezawa-shi Yamagata-ken 992-1128 (JP); Umetsu, Shigehiro, Yonezawa-shi Yamagata-ken 992-1128 (JP)
(74) Representative: Sajda, Wolf E.

(57) **Abstract**

It is an object of the present invention to easily adjust the percentage of each component when mixing together several film formation materials, so as to prevent deviation among film formation areas. A film formation source (10) of a vacuum film formation apparatus (30) comprises: a plurality of material accommodating units (11A,11B) containing a plurality of film formation materials; a plurality of heating means (12A, 12B) for heating the film formation materials contained within the material accommodating units (11A, 11B); a plurality of discharge outlets (13A,13B) for discharging atom flows or molecule flows of film formation materials; apluralityof discharge passages (14₁A, 14₂A, 14₃A, 14₁B, 14₂B, 14₃B) for air-tightly communicating the material accommodating units (11A,11B) with discharge outlets (13A, 13B). Two groups of discharge outlets (13A, 13B) each for discharging an identical film formation material are arranged in one direction, in a manner such that two elongated discharge areas (S₁A,S₁B,S₂A,S₂B) formed by linearly connecting the outer edges of the discharge outlets (13A,13B) are at least partially overlapped with each other when viewed from overhead.

## Description

### BACKGROUND OF THE INVENTION

The present invention relates to a film formation source, a vacuum film formation apparatus, and a method of manufacturing an organic EL panel.

As a technique which forms a thin film on a substrate, there has been known a vacuum film formation (such as vacuum vapor deposition and molecular beam epitaxy). In vacuum vapor deposition, a film formation material is heated and thus sublimated or evaporated to generate an atom flow or molecule flow of the film formation material which is then emitted to a film formation surface of a substrate disposed within a vacuum film formation room (vacuum chamber), thereby allowing the film formation material to adhere to the film formation surface and thus forming a thin film thereon. Usually, a vacuum film formation apparatus which performs such a vacuum film formation has a basic structure comprising 1) a film formation source including at least material accommodating units called crucibles or cells for accommodating film formation material and heating means for heating the film formation material, and 2) the vacuum film formation chamber mentioned above.

Such a vacuum film formation is adopted in carrying out a thin film formation for forming various electronic materials. In particular, when manufacturing organic EL devices which receive considerable attention in recent years as essential display elements for a self-emission type flat display panel, the above-mentioned vacuum film formation has been used to form on a substrate electrodes or an organic layer containing a luminescent layer.

However, in the above-mentioned vacuum film formation, it is sometimes necessary to mix together several sorts of film formation materials to perform film formation on a common film formation surface. For example, in manufacturing an organic EL panel obtained by forming the aforementioned organic EL devices on a substrate, if it is impossible to obtain a desired luminescence characteristic or film formation characteristic using only single one film formation material during a film formation for forming an organic luminescent layer, a plurality of film formation materials will be mixed together to perform a desired film formation. Further, in forming a luminescent layer there has been generally in use a method called Coloring Matter Doping which mixes into a host material an extremely small amount of guest material (dopant coloring matter) which has a high luminance but itself alone fails to be luminescent.

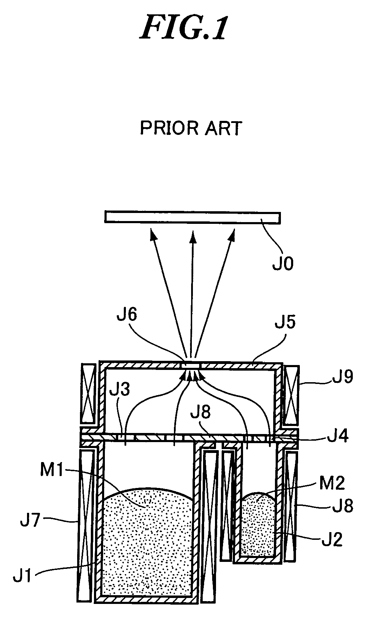

Fig. 1 is an explanatory view showing a film formation source used in a conventional vacuum film formation apparatus (vacuum vapor deposition apparatus) disclosed in Japanese Unexamined Patent Application Publication No. 2003-155555. As shown, regarding a film formation source, when two film formation materials M1 and M2 are mixed with each other to perform a film formation on a common film formation surface (substrate J0), the molecules of film formation materials M1 and M2 discharged from a plurality of crucibles J1 and J2 containing respectively film formation materials M1 and M2 are mixed in a mixing chamber J5 and then discharged through a discharge outlet J6.

In more detail, provided around the respective crucibles J1 and J2 are heaters J7 and J8 for heating and thus evaporating or sublimating the film formation materials M1 and M2 so as to generate molecule flows. Further, a cover plate J8 is provided on the upper openings of the crucibles J1 and J2 so as to close these openings, with inlets J3 formed in the cover plate J8 but located on the crucible J1 side and other inlets J4 similarly formed on the cover plate J8 but located on the crucible J2 side. Moreover, a mixing chamber J5 is formed on the cover plate J8. Here, although a plurality of inlets J3 and a plurality of inlets J4 are provided, a ratio of a total area of the inlets J3 to a total area of the inlets J4 is set corresponding to a molecular ratio of the film formation material M1 to the film formation material M2 for forming film on a substrate J0.

According to the above-discussed prior art, two sorts of film formation materials M1 and M2 are mixed uniformly with each other within the mixing chamber J5 and emitted from a discharge outlet J6, so that there is no component un-uniformity in the film formed on the substrate J0, thereby forming a thin film having a uniform molecular ratio everywhere.

However, the above-discussed prior art has been confronted with a problem that the film formation material M1 diffuses and thus invades from the mixing chamber J5 to the crucible J2, resulting in an undesired mixing of the film formation material M1 with the film formation material M2 and a clogging of the inlet J3 or J4. Accordingly, when performing a film formation using a host material (host material: film formation material M1; guest material: film formation material M2), it is impossible to correctly control the concentration of the film formation material M2 (guest material) and monitor the film formation rate of the film formation material M2.

Besides, in order to prevent precipitation of the film formation material M1 (or M2), the mixing chamber J5 is kept at the same temperature as the crucible J1 (or J2) containing a film formation material having the highest film formation temperature, or is heated to a higher temperature than the crucible J1 (or J2). This however can cause a problem that the film formation material M2 (or M1) will be overheated and thus deteriorates the film formation material.

On the other hand, if discharge paths are individually formed from the respective crucibles J1 and J2 so as to form discharge outlets for discharging the respective film formation materials, positional difference will be present between these discharge outlets even if they are disposed at very close positions to each other. As a result, deviations will occur between film formation areas of various film formation materials on film formation surface. In particular, when film formation is performed only in some specific areas through a shadow mask (a film formation mask), the aforementioned deviation among film formation areas will be more remarkable, causing common film formation areas of film formation materials (subject tomixing) to deviate from specific film formation areas determined by the mask, or causing some film formation areas to be partially overlapped by their adjacent film formation areas.

Moreover, when manufacturing an organic EL panel, if a shadow mask is employed to perform a discriminated painting using different film formation materials having different luminescent colors, the aforementioned positional deviation among film formation areas will cause some color deviations, rendering it impossible to perform film formations of appropriate colors in desired film formation areas.

### SUMMARY OF THE INVENTION

The present invention has been accomplished in order to solve the aforementionedproblem and it is an obj ect of the present invention to ensure an easy adjustment of component percentage when mixing several different film formation materials, to prevent positional deviations among film formation areas, thereby producing an improved organic EL panel free from any color deviation.

In order to achieve the above objects of the present invention, a film formation source, a vacuum film formation apparatus and an organic ELpanel manufacturing method using the film formation source and the vacuum film formation apparatus are characterized by at least the following aspects.

According to one aspect of the present invention, there is provided a film formation source for use in a vacuum film formation apparatus, wherein atom flows or molecule flows of a plurality of film formation materials formed by heating and thus sublimating or evaporating a plurality of film formation materials are emitted to a common film formation surface to form film on the common film formation surface. This film formation source comprises: a plurality of material accommodating units containing a plurality of film formation materials; heating means for heating the film formation materials contained within the material accommodating units; discharge outlets each for discharging an atom flow or a molecule flow of one film formation material; and discharge passages forming airtight communications between the material accommodating units and the discharge outlets. In particular, several groups of discharge outlets each for discharging an identical film formation material are arranged in one direction, in a manner such that several elongated discharge areas formed by linearly connecting the outer edges of the discharge outlets are at least partially overlapped with each other when viewed from overhead.

According to another aspect of the present invention, there is provided a vacuum film formation apparatus having a film formation source wherein atom flows or molecule flows of a plurality of film formation materials formed by heating and thus sublimating or evaporating a plurality of film formation materials are emitted to a common film formation surface to form film on the common film formation surface. The film formation source comprises: a plurality of material accommodating units containing a plurality of film formation materials; heating means for heating the film formation materials contained within the material accommodating units; discharge outlets each for discharging an atom flow or a molecule flow of one film formation material; and discharge passages forming airtight communications between the material accommodating units and the discharge outlets. In particular, several groups of discharge outlets each for discharging an identical film formation material are arranged in one direction, in a manner such that several elongated discharge areas formed by linearly connecting the outer edges of the discharge outlets are at least partially overlapped with each other when viewed from overhead.

### BRIEF DESCRIPTION OF THE DRAWINGS

These and other objects and advantages of the present invention will become clear from the following description with reference to the accompanying drawings, wherein:
Fig. 1 is an explanatory view showing a prior art;
Fig. 2 is a perspective view showing a film formation source of a vacuum film formation apparatus according to an embodiment of the present invention;
Fig. 3 is an explanatory view showing discharge areas of a film formation source according to an embodiment of the present invention;
Fig. 4 is an explanatory view showing discharge areas of a film formation source according to an embodiment of the present invention;
Fig. 5 is an explanatory view showing discharge areas of a film formation source according to an embodiment of the present invention;
Fig. 6A is a perspective view showing a film formation source according to another embodiment of the present invention, and Fig. 6B is an explanatoryview showing discharge areas of the film formation source according to the embodiment of the present invention;
Fig. 7 is an explanatory view showing discharge outlets of a film formation source according to another embodiment of the present invention;
Fig. 8 is an explanatory view showing a film formation source according to an embodiment of the present invention;
Fig. 9 is an explanatory view showing a vacuum film formation apparatus according to an embodiment of the present invention;
Fig. 10 is an explanatory view showing a vacuum film formation apparatus according to another embodiment of the present invention;
Figs. 11A to 11C are explanatory views showing a method of manufacturing an organic EL panel using a vacuum film formation apparatus according to an embodiment of the present invention; and
Fig. 12 is an explanatory view showing an example of an organic EL panel manufactured by the organic EL panel manufacturing method according to an embodiment of the present invention.

### DETAILED DESCRIPTION OF THE PREFERRED EMBODIMENTS

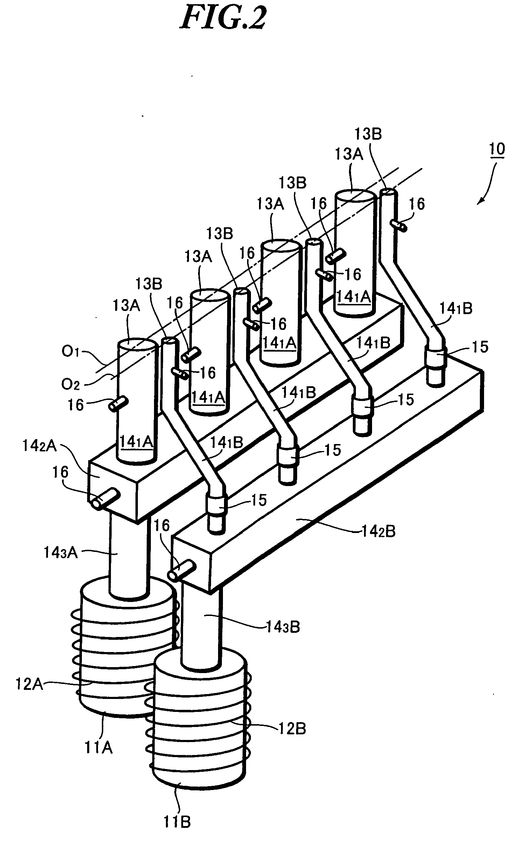

Preferred embodiments of the present invention will be described below with reference to the accompanying drawings. Fig. 2 is an explanatory view showing a film formation source for use in a vacuum film formation apparatus according to one embodiment of the present invention. In fact, the film formation source 10 is formed to heat and thus sublimate or evaporate several different sorts of film formation materials so as to produce a plurality of atom flows or molecule flows of different film formation materials and to emit the same to a common film formation surface to form films of the film formation materials on the film formation surface. Here, although the illustrated example only shows two film formation materials mixed together, the present invention also includes mixing three or more different film formation materials to perform desired film formation.

As shown, the film formation source 10 comprises a plurality of material accommodating units 11A and 11B containing different film formation materials, heating means 12A and 12B for heating the film formation materials contained within the material accommodating units 11A and 11B, discharge outlets 13A and 13B for individually emitting atom or molecule flows of film formation materials, discharge passages 14₁A, 14₂A, 14₃A, 14₁B, 14₂B, and 14₃B forming an airtight communication between the material accommodating units 11A, 11B and the discharge outlets 13A, 13B.

The film formation source 10 is so formed that two groups of discharge outlets 13A, 13B each for discharging an identical film formation material are arranged in one direction, in a manner such that two elongated discharge areas formed by linearly connecting the outer edges of the discharge outlets 13A, 13B are at least partially overlapped with each other when viewed from overhead.

Moreover, one of the discharge passages 14₁A, 14₂A, 14₃A, 14₁B, 14₂B, and 14₃B is provided with flow adjusting means 15 for adjusting atom flows or molecule flows of a film formation material. Here, although the example illustrated in Fig. 2 shows that only the discharge passages 14₁B are provided with flow adjusting means 15, the present invention should not be limited by this. In fact, it is also possible to provide similar flow adjusting means on other discharge passages. Specifically, the flow adjusting means 15 may be formed by a flow rate variable adjusting valve or the like.

Furthermore, each of the discharge passages 14₁A, 14₂A, 14₃A, 14₁B, 14₂B, and 14₃B is provided with an inspection port 16 at a desired position, as well as a detector (such as a thickness monitor or the like but not shown in the drawing) in relation to the inspection port 16, thereby making it possible to grasp the discharge rate of each discharge passage in accordance with the detection result of the corresponding detector. In this way, by adjusting the flow adjusting means 15 or the heating means 12A and 12B in response to the detection result, it is possible to individually adjust the film formation rate of each film formation material discharged from each discharge outlet.

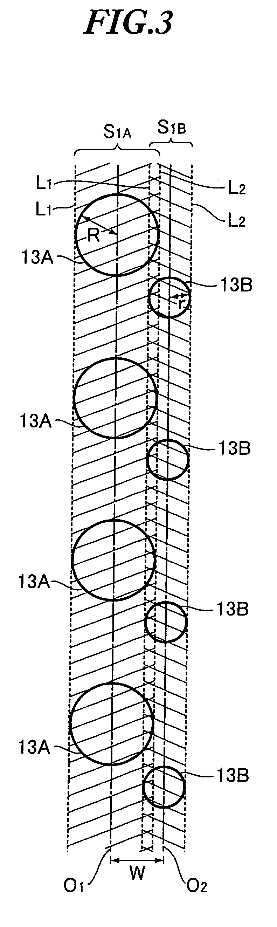

Next, the aforementioned emission areas will be described in more detail with reference to Figs. 3 - 5. As shown, each emission area is formed by standardizing the covering ranges of a plurality of discharge outlets for discharging an identical material. Here, an emission area S_{1A} or the like means an elongated area formed between straight lines L₁ and L₂, with the straight line L₁ connecting the rightmost edges of the respective discharge outlets 13A and the straight line L₂ connecting the leftmost edges of the respective discharge outlets 13A, all arranged in one direction for discharging an identical material. In addition, although an example illustrated herein shows that two sorts of film formation materials are emitted, it is also possible to set an emission area by arranging discharge outlets for emitting three or more sorts of film formation materials.

In an example shown in Fig. 3, the discharge outlets include a plurality of first discharge outlets 13A having circular openings for discharging a first film formation material and a plurality of second discharge outlets 13B having circular openings for discharging a second film formation material. Further, an interval W between a straight line O₁ connecting the centers of the first discharge outlets 13A and a straight line O₂ connecting the centers of the second discharge outlets 13B is set to be smaller than the sum (R+r) of the radii R and r of the first and second discharge outlets (W < (R+r)), thereby rendering the discharge areas S1A and S1B to be partially overlapped with each other when viewed from overhead. Here, although Fig. 3 shows that the discharge outlets have circular openings, it is also possible to form polygonal discharge outlets.

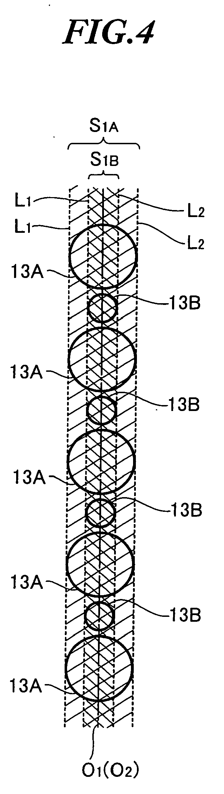

Fig. 4 shows an arrangement formed by modifying the arrangement of Fig. 3, indicating that the emissions areas S₁B are completely contained in the emission areas S₁A. At this time, the aforementioned interval W is zero (straight lines O₁ and O₂ are completely overlapped with each other).

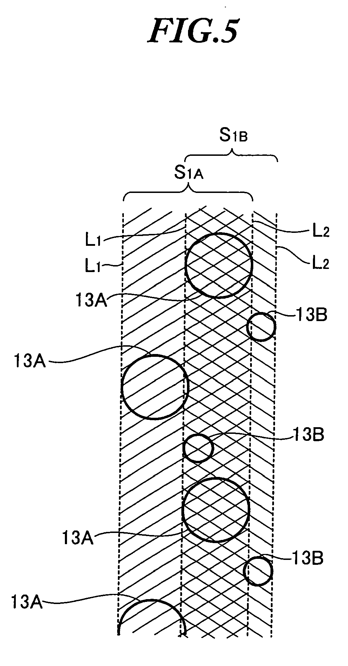

An example of Fig. 5 shows that a plurality of first discharge outlets 13A having circular openings for discharging a first film formation material and a plurality of second discharge outlets 13B having circular openings for discharging a second film formation material are arranged alternately, thereby substantially enlarging the emission areas S_{1A} and S_{1B} without enlarging the discharge outlets 13A and the discharge outlets 13B.

With regard to the film formation source 10, the material accommodating units 11A and 11B are heated by the heating means 12A and 12B, so that the film formation materials contained in the material accommodating units 11A and 11B are sublimated or evaporated, thereby allowing atom or molecule flows of film formation materials to flow through the discharge passages 14₁A, 14₂A, 14₃A, 14₁B, 14₂B, and 14₃B. At this time, the essential elements of the discharge passages 14₁A, 14₂A, 14₃A, 14₁B, 14₂B, and 14₃B are heated by heating means, but required to be maintained at an appropriate temperature which does not cause precipitation or decomposition of film formation materials. In this way, the film formation materials sublimated or evaporated in the material accommodating units 11A and 11B are allowed to flow through the discharge passages 14₁A, 14₂A, 14₃A, 14₁B, 14₂B, and 14₃B and discharged through the discharge outlets 13A and 13B. Subsequently, the discharged atom or molecule flows are mixed with each other in the vacuum film formation chamber and on the film formation surface, so as to be piled up on the film formation surface.

At this time, since the emission areas S_{1A} and S_{1B} are completely overlapped with each other, when different film formation materials are emitted through different emission areas and formed into a film on the film formation surface, it is possible to inhibit deviations among film formation areas of various film formation materials. Accordingly, when a plurality of film formation materials are mixed with one another and formed into a film on the film formation surface, it is possible to form, inadesiredarea, a filmcontainingaplurality of film formation materials uniformly mixed together.

In particular, when film formation is performed through a shadow mask serving as a film formation mask in an area set in accordance with an aperture pattern, or when film formation is performed through a shielding plate restricting an area of film formation, emissions areas S_{1A} and S_{1B} can be formed along the aperture pattern of the film formation mask as well as along the restricting direction of the shielding plate, so that it is possible to form film formation areas of different film formation materials on the film formation surface with only an insignificant deviating amount which does not cause any serious problem in actual use. In this way, it is possible to ensure that a specific material component will not extend from a predetermined area set by the shadow mask so as to avoid any unfavorable influence on adjacent film formation areas and to avoid the formation of areas containing non-mixed materials in predetermined areas.

Moreover, in the film formation source 10, the discharge outlets 13A and 13B are arranged independently from one another, with each outlet corresponding to one kind of film formation material. Similarly, the discharge passages 14₁A, 14₂A, 14₃A, 14₁B, 14₂B, and 14₃B extending to the discharge outlets 13A and 13B are also arranged independently from one another, with each passage corresponding to one kind of film formation material. In this way, it is possible to adjust or control the states of the respective film formation materials flowing through the discharge passages. As a result, it is possible to optionally adjust the percentages of film formation materials being mixed together.

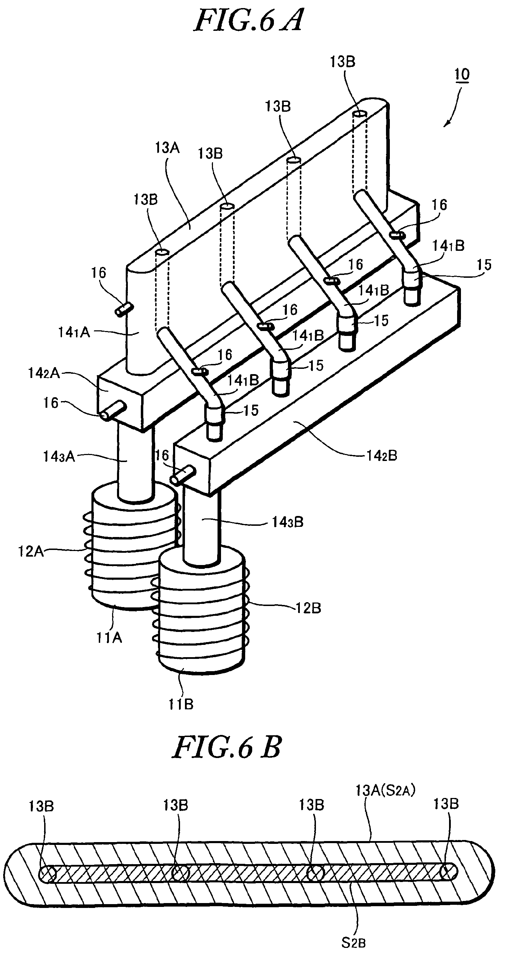

Fig. 6 shows another embodiment of the film formation source 10 according to the present invention (the same parts as those in the above-described embodiment are represented by the same reference numerals, and the same description thereof will not be repeated herein). In this embodiment, a discharge outlet 13A for discharging one kind of film formation material is not an independent nozzle, but a single linear (long and narrow) opening. Further, discharge passages 14₁B communicated with discharge outlets 13B are inserted into a discharge passage 14₁A communicated with the discharge outlet 13A, in a manner such that discharge outlets 13B for discharging one more film formation material are formed in the discharge outlet 13A.

In the present embodiment, the opening itself of the discharge outlet 13A forms an emission area S2A, while a discharge area S2B formed by the discharge outlets 13B is contained within the emission area S2A, thereby forming an overlapped arrangement.

In this manner, the present embodiment makes it possible to obtain the same effect as obtainable in the above-described embodiment. In particular, the discharge outlet 13A formed into single one linear opening is used to discharge a host material having a higher mixing percentage, while the nozzle-like discharge outlets 13B arranged within the discharge outlet 13A are used to discharge guest materials to be mixed into the host material, thereby rendering it possible to easily obtain a discharge state of atom flow or molecular flow corresponding to an actual mixing rate. Moreover, if eachof the discharge passages 14₁B isprovidedwitha flowadjusting device 15 to adjust the flow rates of the guest materials, it is possible to correctly and easily perform a fine adjustment required for adjusting guest materials.

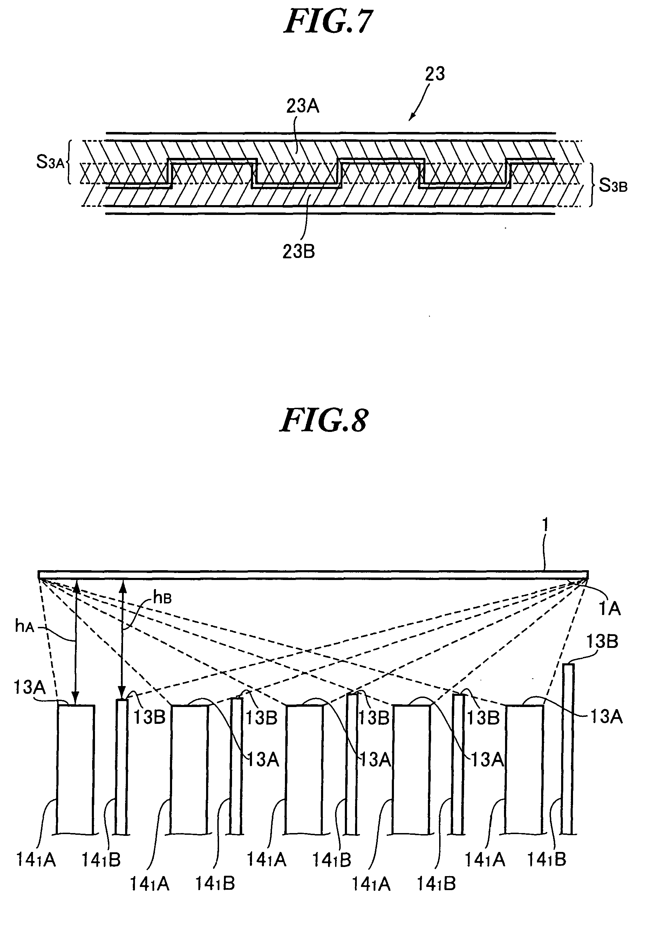

Fig. 7 is an explanatory view showing another embodiment of discharge outlet. In this embodiment, a discharge outlet 23 is formed by discharge outlets 23A and 23B each having a linear configuration, with different film formation materials discharged from different discharge outlets. Further, according to the present embodiment, two-dimensional concavo-convex portions are formed along the boundary between the discharge outlets 23A and 23B, and these concavo-convex portions are engaged with each other on two-dimensional plane, in a manner such that a discharge area S_{3A} formed by the discharge outlet 23A and a discharge area S_{3B} formed by the discharge outlet 23B are overlapped with each other.

Therefore, the present embodiment makes it possible to obtain the same effect as obtainable in the above-described embodiment. In particular, an arrangement according to the present embodiment can be effectively used to ensure mutually equal mixing rates of two film formation materials, so as to ensure a film formation having less directivity in linear (longitudinal) direction.

In addition, an arrangement of discharge outlets in the above-described embodiments should not receive any restriction, provided that related discharge areas are overlapped with each other in two-dimensional plane, with the height of three-dimensional discharge outlets being properly set in accordance with actual needs. For example, as shown in Fig. 8, with respect to the film formation surface 1A of the substrate 1, a distance h_{A} from the discharge outlets 13A and a distance h_{B} from the discharge outlets 13B are allowed to be different from each other. At this time, it is preferable that each discharge outlet 13B does not enter a space defined by a straight line connecting a discharge outlet 13A and the film formation area of the substrate 1. By virtue of such an arrangement, there will not be any trouble that film formation operation is hampered due to the presence of the discharge outlets 13B. On the other hand, if the discharge outlets 13B are reduced in their size to such an extent that no unfavorable influence is caused, the above-mentioned arrangement will be unnecessary.

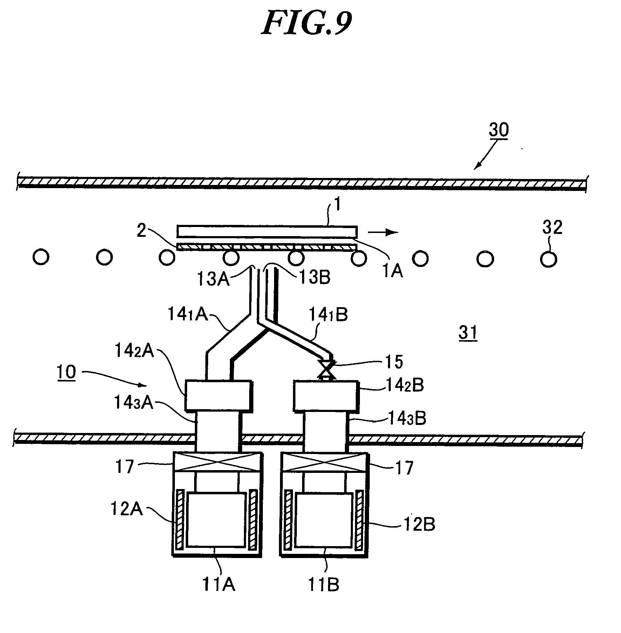

Fig. 9 is an explanatory view showing an example of a vacuum film formation apparatus 30 formed according to one more embodiment of the present invention. In fact, the vacuum film formation apparatus 30 is an apparatus for carrying out film formation on the film formation surface 1A of the substrate 1 by using the above-described film formation source 10. As shown, the vacuum film formation apparatus 30 comprises a vacuum film formation chamber 31 in which the substrate 1 is disposed, and a conveyer device 32 for moving the substrate 1 relative to the film formation source 10 in the vacuum film formation chamber 31. In the illustrated example, the material accommodating units 11A and 11B of the film formation source 10 are disposed outside the vacuum film formation chamber 31, while the discharge passages 14₃A and 14₃B are introduced into the vacuum film formation chamber 31 through shutter valves 17. A discharge areas formed by the discharge outlets 13A and 13B extend in a direction perpendicular to the paper surface, while the substrate 1 is moved in a direction shown by an arrow which is perpendicular to the extending direction of the discharge areas. Further, as the conveyer device 32 used in the present embodiment it is allowed to be a roller-type conveyer device or the like.

Moreover, the vacuum film formation apparatus 30 according to the present embodiment of the present invention employs a shadow mask 2 disposed to face the film formation surface 1A of the substrate 1, while the aperture pattern of the shadow mask 2 is formed in compliance with the discharge areas formed by the discharge outlets 13A and 13B. In this way, while the substrate 1 is being moved by the conveyer device 32, the film formation materials being discharged from the discharging outlets 13A and 13B are allowed to form film in areas corresponding to the aperture pattern of the shadow mask 2, thereby forming an in-line type vacuum film formation apparatus.

According to the vacuum film formation apparatus 30, the discharge areas formed by the discharge outlets 13A and 13B are overlapped with each other and extend in compliance with the aperture pattern of the shadow mask 2. Therefore, in the film formation areas determined by the aperture pattern of the shadow mask 2, it is possible to effect film formation using an amount of film formation material formed by uniformly mixing together a material discharged from the discharge outlet 13A and another material discharged from the discharge outlet 13B. Moreover, since the discharge areas are overlapped with each other, a deviation of the film formation area formed by the discharge outlet 13A and a deviation of the film formation area formed by the discharge outlet 13B are all enclosed within an actually allowable range, thereby enabling the film formation areas to be substantially coincident with film formation areas defined by the shadow mask 2.

Furthermore, since the discharge areas formed by the discharge outlets 13A and 13B are formed extending in one direction, these discharge areas are suitable for linear film formation, thus making it possible to form wide and uniform linear film formation area in a direction perpendicular to the moving direction of the substrate 1. Therefore, when using the shadow mask 2 formed with large slots in a direction perpendicular to the moving direction of the substrate 1, it is possible to ensure a uniform film formation in directions in compliance with the aperture pattern of the shadow mask.

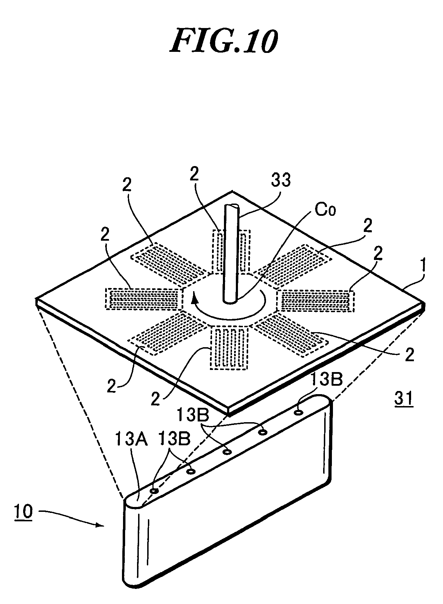

Fig. 10 is an explanatory view showing one more embodiment of a vacuum film formation apparatus formed according to the present invention. In this embodiment, there is provided a moving device 33 for relatively moving the substrate 1 with respect to the film formation source 10 in the vacuum film formation chamber 31 in the same manner as the previously described embodiment. In fact, the moving device 33 is provided for rotating the substrate 1 with respect to the extending directions of the discharge areas formed by the discharge outlets 13A and 13B. At this time, the substrate 1 is provided with the shadow mask 2 formed with aperture patterns in the radial direction with respect to the rotating center Cₒ. Specifically, the present embodiment employs a cluster type vacuum film formation apparatus which takes out and puts into as well as disposes the substrate 1 in the vacuum film formation chamber 31 by using a transporting device (such as a robot arm or the like) . In this way, similar to those described above, since the discharge areas are over lapped with each other, a deviation of the film formation area formed by the discharge outlet 13A and a deviation of the film formation area formed by the discharge outlet 13B are all enclosed within an actually allowable range, thereby enabling the film formation areas to be substantially coincident with film formation areas defined by the shadow mask 2.

In addition, the vacuum film formation apparatus 30 according to the above-described embodiment of the present invention is allowed to employ any one of various known heating devices involving resistance heating, high frequency heating, laser heating or electron beam heating. Preferably, the vacuum film formation chamber 31 is set at a high vacuum state (10⁻⁴ Pa or lower), resistance heating is performed by winding high melting point metal filament or boat-like heating coil formed by tantalum (Ta) , molybdenum (Mo) or tungsten (W), and material accommodating units 11A and 11B are formed by high melting point oxide suchas alumina (Al₂O₃) and beryllia (BeO), thus forming heating apparatus 12A and 12B, thereby making it possible to form heating devices capable of heating by flowing an electric current through the heating coils. Moreover, it is also possible to form a cluster type apparatus for individually treating substrates as described above, as well as an in-line type apparatus for continuously treating the substrates.

Moreover, although the illustrated example shows that the discharge outlets 13A and 13B are disposed to face upwardly and the film formation surface 1A is disposed to face downwardly, the present invention should not be limited by this. Actually, it is also possible for the discharge outlets 13A and 13B to face horizontally and the film formation surface 1A to face the discharge outlets 13A and 13B, so that both the film formation surface 1A and the substrate 1 are disposed in vertical position. Here, the shape of each discharge outlet is not absolutely necessary to be circle, but also allowed to be rectangular or polygonal.

Therefore, the vacuum film formation apparatus 30 according to the present invention of the present invention is suitable for carrying out a method of manufacturing an organic EL panel. An organic EL panel is obtained by forming on a substrate at least one organic EL device formed by interposing an organic layer containing an organic luminescent layer between a pair of electrodes. In practice, the above-described vacuum film formation apparatus 30 can be used to deposit on the substrate 1 at least one film formation material for forming the electrodes or organic layer.

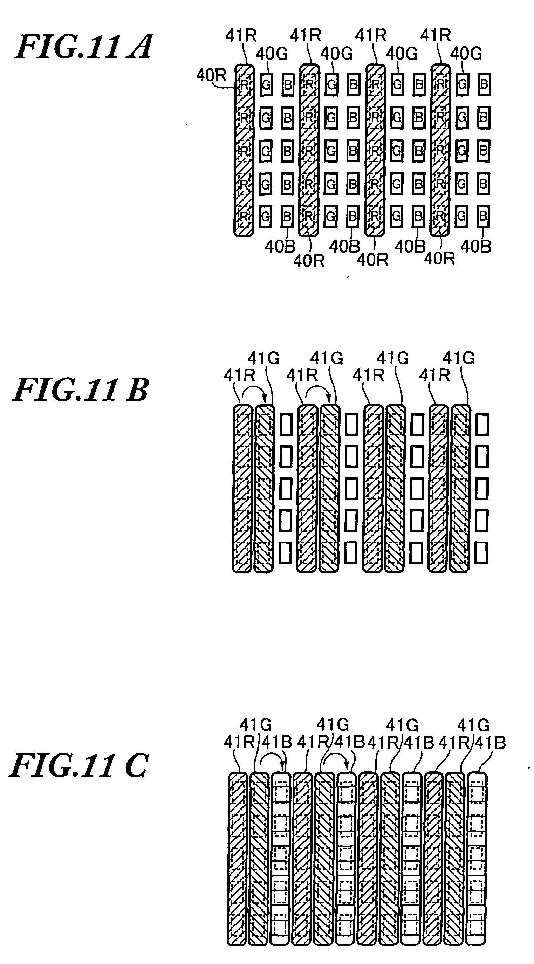

Figs. 11A to 11C are explanatory views showing an example of manufacturing an organic EL panel by using the above-described vacuum film formation apparatus 30. In the following, description will be given to explain an example of painting a luminescent layer with three different colors R, G, B. In detail, the example employs a shadow mask having a plurality of linear openings. One operation of film formation forms one color of stripe-like film area, so that mutually adjacent three colors R, G, B of film areas can be formed by performing three operations of painting three different colors.

At first, as shown in Fig. 11A, with respect to luminescent areas 40R, 40G, and 40B (which are openings formed by dividing the lower electrodes on the substrate using insulating films) formed on the substrate, the opening portions of the shadow mask (not shown) are positioned on the luminescent areas 40R, so that the first operation of film formation can be performed to form film areas 41R of the luminescent layers of color R.

Next, as shown in Fig. 11B, the opening portions of the shadow mask are positioned on the luminescent areas 40G adjacent to the formed film areas 41R, so that the second operation of film formation can be performed to form film areas 41G of the luminescent layers of color G. Further, as shown in Fig. 11C, the opening portions of the shadowmask are positioned on the luminescent areas 40Badjacent to the formed film areas 41G, so that the third operation of film formation can be performed to form film areas 41B of the luminescent layers of color B.

In this way, when painting the film formation areas 41R, 41G, and 41B with different colors using the vacuum film formation apparatus 30 of the present invention, it is possible to avoid color deviations among film formation areas 41R, 41G, and 41B of various colors. Namely, when a host material forming a luminescent layer is mixed with guest materials consisting of coloring matters serving as dopants, actual film formation areas will be substantially coincident with the film formation areas determined by the openings of the shadowmask, thereby ensuring film formations in film formation areas consisting of host material and film formation areas consisting of guest materials, with deviations of amounts not causing any problems in actual use. In this way, there would not be any specific coloring components to extend beyond preset areas determined by the shadow mask or the like, nor will any areas containing non-mixed materials be formed in any preset areas, thereby eliminating any color deviations in luminescent areas.

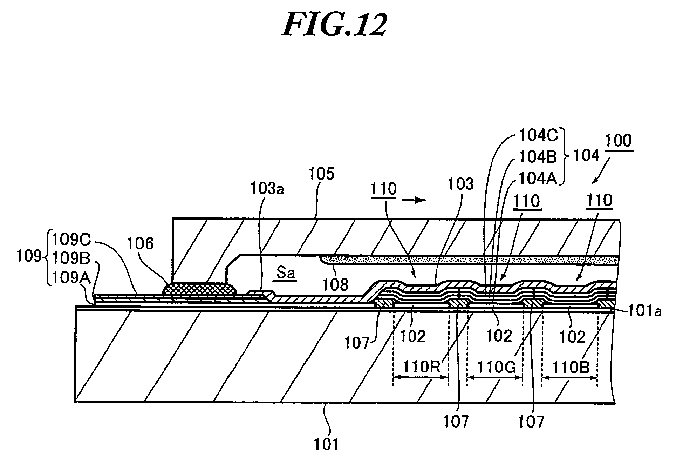

Fig. 12 is an explanatory view showing an example of an organic EL panel manufactured by using the above-described manufacturing method.

As shown, an organic EL panel 100 is formed by interposing an organic layer 104 containing an organic luminescent layer between first electrodes 102 on one hand and second electrodes 103 on the other, thereby forming a plurality of organic EL devices 110 on the substrate 101. In an example shown in Fig. 12, a silicone coating layer 101a is formed on the substrate 101, and a plurality of first electrodes 102 consisting of transparent electrode material such as ITO and serving as cathodes are formed on the silicon coating layer 101a. Further, second electrodes 103 consisting of a metal and serving as anodes are formed above the first electrodes 102, thereby forming a bottom emission type panel producing light from the substrate 101 side. Moreover, the panel also contains an organic layer 104 including a positive hole transporting layer 104A, a luminescent layer 104B, and an electron transporting layer 104C. Then, a cover 105 is bonded to the substrate 101 through an adhesive layer 106, thereby forming a sealing space Sa on the substrate 101 and thus forming a display section consisting of organic EL devices 110 within the sealing space Sa.

In the example shown in Fig. 12, the organic EL devices 110 are formed such that the first electrodes 102 are separated by a plurality of insulating strips 107, thereby forming luminescent units (110R, 110G, 110B) under the first electrodes 102. Moreover, a desiccant layer 108 is attached to the inner surface of the cover 105 forming the sealing space Sa, thereby preventing the organic EL devices 110 from getting deteriorated due to moisture.

Moreover, along the edge of the substrate 101 there is formed a first electrode layer 109A using the same material and the same step as forming the first electrodes 102, which is separated from the first electrodes 102 by the insulating strips 107. Further, on the lead-out portion of the first electrode layer 109A there is formed a second electrode layer 109B containing a silver alloy or the like and forming a low-resistant wiring portion. In addition, if necessary, a protection coating layer 109C consisting of IZO or the like is formed on the second electrode layer 109B. In this way, a lead-out electrode 109 can be formed which consists of the first electrode layer 109A, the second electrode layer 109B, and the protection coating 109C. Then, an endportion 103a of each second electrode 103 is connected to the lead-out electrode 109 within the sealing space Sa.

Here, although the lead-out electrode of each first electrode 102 is not shown in the drawing, it is possible to elongate each first electrode 102 and lead the same out of the sealing space. Actually, such lead-out electrode can also be formed into an electrode layer containing Ag or the like and constituting a low resistant wiring portion, similar to an example associated with the above-described second electrode 103.

Next, description will be given to explain in detail the organic EL panel 100 and the method of manufacturing the same, according to one embodiment of the present invention.

### a. Electrodes

Either the first electrodes 102 or the second electrodes 103 are set as cathode side, while the opposite side is set as anode side. The anode side is formed by a material having a higher work function than the cathode side, using a transparent conductive film which may be a metal film such as chromium (Cr), molybdenum (Mo), nickel (nickel), and platinum (Pt), or a metal oxide film such as ITO and IZO. In contrast, the cathode side is formed by a material having a lower work function than the anode side, using a metal having a low work function, which may be an alkali metal (such as Li, Na, K, Rb, and Cs), an alkaline earth metal (such as Be, Mg, Ca, Sr, and Ba) , a rare earth metal, a compound or an alloy containing two or more of the above elements, or an amorphous semiconductor such as a doped polyaniline and a doped polyphenylene vinylene, or an oxide such as Cr₂O₃, NiO, and Mn₂O₅. Moreover, when the first electrodes 102 and the second electrodes 103 are all formed by transparent materials, it is allowed to provide a reflection film on one electrode side opposite to the light emission side.

The lead-out electrodes (the lead-out electrode 109 and the lead-out electrode of the first electrodes 102) are connected with drive circuit parts driving the organic EL panel 100 or connected with a flexible wiring board. However, it is preferable for these lead-out electrodes to be formed as having a low resistance. Namely, the lead-out electrodes can be formed by laminating low resistant metal electrode layers which may be Ag, Cr, A1, or may be formed by single one electrode of low resistant metal.

### b. Organic layer

Although the organic layer 104 comprises one or more layers of organic compound materials including at least one organic luminescent layer, its laminated structure can be in any desired arrangement. Usually, as shown in Fig. 12, there is a laminated structure including, from the anode side towards the cathode side, a hole transporting layer 104A, a luminescent layer 104B, and an electron transporting layer 104C. Each of the hole transporting layer 104A, the luminescent layer 104B, and the electron transporting layer 104C can be in a single-layer or a multi-layered structure. Moreover, it is also possible to dispense with the hole transporting layer 104A and/or the electron transporting layer 104C. On the other hand, if necessary, it is allowed to insert other organic layers including a hole injection layer, an electron injection layer and a carrier blocking layer. Here, the hole transporting layer 104A, the luminescent layer 104B, and the electron transporting layer 104C can be formed by any conventional materials (it is allowed to use either a high molecular material or a low molecular material).

With regard to a luminescent material for forming the luminescent layer 104B, it is allowed to make use of a luminescence (fluorescence) when the material returns from a singlet excited state to a base state or a luminescence (phosphorescence) when it returns from a triplet excited state to a base state.

### c. Covering Member (Covering Film)

Further, the organic EL panel 100 according to the present invention is a panel formed by tightly covering organic EL devices 110 with a covering member 105 made of metal, glass, or plastic. Here, the covering member may be a piece of material having a recess portion (a one-step recess or a two-step recess) formed by pressing, etching, or blasting. Alternatively, the covering member may be formed by using a flat glass plate and includes an internal covering space Sa to be formed between the flat glass plate and the support substrate by virtue of a spacer made of glass (or plastic).

In order to tightly seal the organic EL devices 110, it is also possible for the covering member 105 to be replaced by a sealing film to cover the organic EL devices 110. The covering film can be formed by laminating a single layer of protection film or a plurality of protection films, and is allowed to be formed by either an inorganic material or an organic material. Here, an inorganic material may be a nitride such as SiN, AlN, and GaN, or an oxide such as SiO, Al₂O₃, Ta₂O₅, ZnO, and GeO, or an oxidized nitride such as SiON, or a carbonized nitride such as SiCN, or a metal fluorine compound, or a metal film, etc. On the other hand, an organic material may be an epoxy resin, or an acryl resin, or a paraxylene resin, or a fluorine system high molecule such as perfluoro olefin and perfluoro ether, or a metal alkoxide such as CH₃OM and C₂H₅OM, or a polyimide precursor, or a perylene system compound, etc. In practice, the above-mentioned lamination and material selection can be carried out by appropriately designing the organic EL devices.

### d. Adhesive Agent

An adhesive agent forming the adhesive layer 106 may be a thermal-setting type, a chemical-setting type (2-liquid mixture), or a light (ultraviolet) setting type, which can be formed by an acryl resin, an epoxy resin, a polyester, a polyolefine. Particularly, it is preferable to use an ultraviolet-setting epoxy resin adhesive agent which is quick to solidify without a heating treatment.

### e. Desiccating Material

Desiccating material 108 may be a physical desiccating agent such as zeolite, silica gel, carbon, and carbon nanotube; a chemical desiccating agent such as alkali metal oxide, metal halogenide, peroxide chlorine; a desiccating-agent formed by dissolving an organic metallic complex in apetroleum system solvent suchas toluene, xylene, an aliphatic organic solvent and the like; and a desiccating agent formed by dispersing desiccating particles in a transparent binder such as polyethylene, polyisoprene, polyvinyl thinnate.

### f. Various Types of Organic EL Display Panels

The organic EL panel 100 of the present invention can have various types without departing from the scope of the invention. For example, the light emission type of an organic EL device 130 can be a bottom emission type emitting light from the substrate 110 side, or a top emission type emitting light from a side opposite to the substrate 110. Moreover, the EL display panel may be a single color display or a multi-color display. In practice, in order to form a multi-color display panel, it is allowed to adopt the foregoing discriminated painting method to perform a multi-color displaying of two or more colors.

Moreover, it is also possible to use another organic EL panel manufacturing method involving an LITI (Laser-induced Thermal Imaging) process in which a donor film formed with a transfer layer containing an electrode or an organic layer is formed on a substrate film, followed by irradiating the substrate film of the donor film with a light pattern, thereby transferring an organic layer from the donor film to the substrate. In this way, by using in a film formation process a donor film employing host/guest system, it is allowed to make effective use of film formation material, and to obtain an effect of controlling the film formation rate of guest materials.

Using the film formation source, the vacuum film formation apparatus, and the organic EL panel manufacturing method according to the embodiments of the present invention, it is possible to easily adjust component percentages when mixing film formation materials. Furthermore, it is possible to prevent deviations among film formation areas, thereby eliminating color deviations when manufacturing an organic EL panel.

## Claims

1. A film formation source (10) for use in a vacuum film formation apparatus (30) , wherein atom flows or molecule flows of a plurality of film formation materials formed by heating and thus sublimating or evaporating a plurality of film formation materials are emitted to a common film formation surface (1A) to form film on the common film formation surface (1A), said film formation source (10) comprising:
a plurality of material accommodating units (11A,11B)containing a plurality of film formation materials;
heating means (12A,12B) for heating the film formation materials contained within the material accommodating units (11A, 11B);
discharge outlets (13A,13B,23A,23B) each for discharging an atom flow or a molecule flow of one film formation material; and
discharge passages (14₁A, 14₂A, 14₃A, 14₁B, 14₂B, 14₃B) forming airtight communications between the material accommodating units (11A,11B)and the discharge outlets (13A,13B,23A,23B),
wherein several groups of discharge outlets (13A,13B,23A,23B)each for discharging an identical film formation material are arranged in one direction, in a manner such that several elongated discharge areas (S₁A,S₁B,S₂A,S₂B) formed by linearly connecting the outer edges of the discharge outlets (13A, 13B, 23A, 23B) are at least partially overlapped with each other when viewed from overhead.

2. The film formation source according to claim 1, wherein the discharge passages (14₁A, 14₂A, 14₃A, 14₁B, 14₂B, 14₃B) are provided with flow adjusting means (15) for adjusting the atom flows or molecule flows of the film formation materials.

3. The film formation source according to claim 1 or 2, wherein the discharge areas are (S₁A, S₁B, S₂A, S₂B) formed in accordance with an aperture pattern of film formation mask.

4. The film formation source according to any one of claims 1 to 3,
wherein the discharge outlets (13A,13B,23A,23B)include a plurality of first discharge outlets comprising openings for discharging a first film formation material and a plurality of second discharge outlets comprising openings for discharging a second film formation material,
wherein an interval between a straight line connecting the centers of the first discharge outlets and another straight line connecting the centers of the second discharge outlets is set to be smaller than a sum of 1/2 outer diameters of the first and second discharge outlets, so that the discharge areas (13A,13B,23A,23B)are at least partially overlapped with each other when viewed from overhead.

5. A vacuum film formation apparatus (30) having a film formation source (10) wherein atom flows or molecule flows of a plurality of film formation materials formed by heating and thus sublimating or evaporating a plurality of film formation materials are emitted to a common film formation surface (1A) to form film on the common film formation surface (1A),
wherein the film formation source (10) comprises:
a plurality of material accommodating units (11A,11B) containing a plurality of film formation materials;
heating means (12A,12B) for heating the film formation materials contained within the material accommodating units (11A,11B);
discharge outlets (13A, 13B, 23A, 23B) each for discharging an atom flow or a molecule flow of one film formation material; and
discharge passages (14₁A, 14₂A, 14₃A, 14₁B, 14₂B, 14₃B) forming airtight communications between the material accommodating units (11A, 11B) and the discharge outlets (13A,13B,23A,23B),
wherein several groups of discharge outlets (13A,13B,23A,23B)each for discharging an identical film formation material are arranged in one direction, in a manner such that several elongated discharge areas (S₁A,S₁B,S₂A,S₂B) formed by linearly connecting the outer edges of the discharge outlets (13A, 13B, 23A, 23B) are at least partially overlapped with each other when viewed from overhead.

6. The vacuum film formation apparatus (30) according to claim 5, including a vacuum film formation chamber (31) which allows a substrate (1) having a film formation surface (1A) to be disposed therein, andmovingmeans (32,33) for moving the substrate (1) within the vacuum film formation chamber (31) relative to the film formation source (10).

7. The vacuum film formation apparatus (30) according to claim 5, wherein the moving means (32) moves the substrate (1) in a direction perpendicular to a direction in which the discharge areas (S₁A, S₁B, S₂A, S₂B) are extending.

8. The vacuum film formation apparatus according to claim 5, wherein the moving means (33) rotates the substrate (1) with respect to a direction in which the discharge areas are extending.

9. A method of manufacturing an organic EL panel formed by forming on a substrate (1) a least one organic EL device which is formed by interposing an organic layer containing an organic luminescent layer between a pair of electrodes,
wherein at least one kind of film formation material for forming the electrodes or the organic layer is formed into a film on the substrate by using the vacuum film formation apparatus (30) recited in any one of claims 6 to 8.

10. The method according to claim 9, wherein different portions of the organic luminescent layer are painted with different colors of luminescent materials through a film formation mask having an aperture pattern coincident with discharge areas (S₁A, S₁B, S₂A, S₂B) .

11. A method of manufacturing an organic EL panel formed by forming on a substrate (1) a least one organic EL device which is formed by interposing an organic layer containing an organic luminescent layer between a pair of electrodes, said method comprising the steps of:
using at least one kind of film formation material for forming the electrodes or the organic layer to form a film on a substrate film so as to form a donor film by using the vacuum film formation apparatus (30) recited in any one of claims 6 to 8,
applying a light pattern to the substrate film of the donor film and transferring the film formation material onto the substrate (1), thereby forming a pattern of the electrodes or the organic layer on the substrate (1).
